# EUROPEAN PATENT APPLICATION

(11) **EP 4 604 180 A1**
(43) Date of publication of application: **20.08.2025**
(21) Application number: 23893130.7
(22) Date of filing: 27.06.2023
(51) Int. Cl.: H01L 29/78, H01L 29/06, H01L 21/336

(54) **GATE-ALL-AROUND TRANSISTOR AND MANUFACTURING METHOD THEREFOR, AND ELECTRONIC DEVICE**

(30) Priority: 22.11.2022 CN 202211468805
(71) Applicant: Huawei Technologies Co., Ltd., Shenzhen, Guangdong 518129 (CN)
(72) Inventor: WANG, Weilin, Shenzhen, Guangdong 518129 (CN); HOU, Zhaozhao, Shenzhen, Guangdong 518129 (CN); BENISTANT, Francis Lionel, Shenzhen, Guangdong 518129 (CN)
(74) Representative: Pfenning, Meinig & Partner mbB
(86) International application number: PCT/CN2023/102928
(87) International publication number: WO 2024/109030

(57) **Abstract**

A gate-all-around transistor, a preparation method thereof, and an electronic device are provided, and belong to the field of semiconductor technologies. A gate-all-around transistor (1) includes a first epitaxial doping layer (041) epitaxially grown between a substrate (01) and a source (031) and a second epitaxial doping layer (042) epitaxially grown between the substrate (01) and a drain (032), to cut off an electricity leakage channel, on the substrate, between the source (031) and the drain (032). Both the first epitaxial doping layer (041) and the second epitaxial doping layer (042) are epitaxially grown on the substrate (01). Therefore, a depletion region including the first epitaxial doping layer (041) and the source (031) is limited in the first epitaxial doping layer (041), a depletion region including the second epitaxial doping layer (042) and the drain (032) is limited in the second epitaxial doping layer (042), and the depletion regions do not extend to the substrate (01). The depletion region including the first epitaxial doping layer (041) and the source (031) and the depletion region including the second epitaxial doping layer (042) and the drain (032) are separated in a direction parallel to the substrate (01), to suppress an electricity leakage of the substrate.

## Description

### CROSS-REFERENCE TO RELATED APPLICATIONS

This application claims priority to Chinese Patent Application No. 202211468805.X, filed with the China National Intellectual Property Administration on November 22, 2022 and entitled "GATE-ALL-AROUND TRANSISTOR, PREPARATION METHOD THEREOF, AND ELECTRONIC DEVICE", which is incorporated herein by reference in its entirety.

### TECHNICAL FIELD

This application relates to the field of semiconductor technologies, and in particular, to a gate-all-around transistor, a preparation method thereof, and an electronic device.

### BACKGROUND

With continuous development of the Moore's law, a transistor in a chip is continuously downscaled, an integration level of the transistor is continuously improved, and a working voltage of the transistor is continuously reduced, to meet requirements of high performance and low power consumption of the chip. From the invention of the first transistor to the current mainstream 5 nm technology node, it has been more than half a century. At each technology node, innovative process technologies are proposed to further promote development of transistors. Continuous downscaling of a feature size of the conventional transistor has reached the physical limit, causing a contradiction between power consumption, performance, and costs of the chip. Therefore, a complementary metal-oxide-semiconductor (Complementary metal-oxide-semiconductor, CMOS) component develops from a two-dimensional planar structure into a 3D fin field-effect transistor (Fin Field-Effect Transistor, Fin FET), and continues to be used in a 5 nm process node. To further extend the Moore's law, the microelectronics academia and industry develop next-generation components based on new materials and new architectures. A gate-all-around (Gate-all-around, GAA) transistor has a better subthreshold swing and a better gate control capability than the fin FET, to obtain better electrical performance. However, there is a parasitic leakage channel from a source to a drain under channel layers stacked in the GAA transistor, which is referred to as a parasitic leakage of a substrate. The parasitic leakage of the substrate is one of main challenges faced by the GAA transistor. As a channel length of the GAAtransistor is continuously downscaled, the parasitic leakage of the substrate becomes severer.

### SUMMARY

This application provides a GAA transistor, a preparation method thereof, and an electronic device, to reduce a parasitic leakage of a substrate of the GAA transistor.

According to a first aspect, this application provides a GAA transistor. The GAA transistor mainly includes a substrate, a fin located on the substrate, a source and a drain that are respectively located on two sides of the fin, and a gate structure that is located between the source and the drain and that covers the fin. To reduce a parasitic leakage of the substrate, the GAA transistor may further include a first epitaxial doping layer and a second epitaxial doping layer that are respectively located on the two sides of the fin. The first epitaxial doping layer is located between the substrate and the source, and the second epitaxial doping layer is located between the substrate and the drain. Conductivity types of doped impurities in the first epitaxial doping layer and the second epitaxial doping layer are the same as a conductivity type of a doped impurity in the substrate, and the conductivity types of the doped impurities in the first epitaxial doping layer and the second epitaxial doping layer counter with conductivity types of doped impurities in the source and the drain. For example, if the conductivity types of the doped impurities in the source and the drain are an N type, conductivity types of doped impurities in the first epitaxial doping layer, the second epitaxial doping layer, and the substrate are a P type. If the conductivity types of the doped impurities in the source and the drain are the P type, the conductivity types of the doped impurities in the first epitaxial doping layer, the second epitaxial doping layer, and the substrate are the N type. However, doping concentrations of the first epitaxial doping layer and the second epitaxial doping layer are greater than a doping concentration of the substrate.

In this application, because the conductivity types of the doped impurities in the first epitaxial doping layer and the second epitaxial doping layer counter with the conductivity types of the doped impurities in the source and the drain, an electricity leakage channel, on the substrate, between the source and the drain may be cut off by using the first epitaxial doping layer and the second epitaxial doping layer on which counter-type doping is performed. In addition, both the first epitaxial doping layer and the second epitaxial doping layer are epitaxially grown on the substrate. Therefore, a depletion region including the first epitaxial doping layer and the source is limited in the first epitaxial doping layer, a depletion region including the second epitaxial doping layer and the drain is limited in the second epitaxial doping layer, and the depletion regions do not extend to the substrate. In addition, the depletion region including the first epitaxial doping layer and the source and the depletion region including the second epitaxial doping layer and the drain are separated in a direction parallel to the substrate, to greatly suppress an electricity leakage of the substrate.

In addition, as a channel length is downscaled, because the depletion region including the first epitaxial doping layer and the source and the depletion region including the second epitaxial doping layer and the drain are separated in the direction parallel to the substrate, the doping concentrations of the first epitaxial doping layer and the second epitaxial doping layer may remain to be low. This avoids a severer BTBT electricity leakage.

Therefore, the GAA transistor provided in this application can obtain a better subthreshold swing, and as the channel length is continuously downscaled, a working voltage may also be continuously decreased while component performance is ensured.

For example, the fin may include a plurality of channel layers stacked at intervals along a direction perpendicular to the substrate, and the gate structure may include two side walls disposed opposite to each other, a gate oxide layer wrapping each channel layer, and a gate layer filling a gap between the two side walls. To isolate the gate layer from the source and the drain, two internal isolation portions are disposed on a side that is of each channel layer and that faces the substrate, the two internal isolation portions are isolated by the gate layer, one internal isolation portion is located between the gate layer and the source, and the other is located between the gate layer and the drain.

In this application, because the depletion region including the first epitaxial doping layer and the source and the depletion region including the second epitaxial doping layer and the drain are separated in the direction parallel to the substrate, the doping concentrations of the first epitaxial doping layer and the second epitaxial doping layer may remain to be low. For example, a doping concentration of the first epitaxial doping layer may be set to be less than or equal to 5*10¹⁸/cm³, and a doping concentration of the second epitaxial doping layer may be set to be less than or equal to 5*10¹⁸/cm³.

In an embodiment, the doping concentration of the first epitaxial doping layer may be controlled to be less than 10¹⁸/cm³, and the doping concentration of the second epitaxial doping layer may be controlled to be less than 10¹⁸/cm³.

Thicknesses of the first epitaxial doping layer and the second epitaxial doping layer are not limited in this application. For example, a thickness of the first epitaxial doping layer may be set to 5 nm to 25 nm, for example, 5 nm, 7 nm, 10 nm, 15 nm, 20 nm, or 25 nm. A thickness of the second epitaxial doping layer may be set to 5 nm to 25 nm, for example, 5 nm, 7 nm, 10 nm, 15 nm, 20 nm, or 25 nm.

For example, in this application, the first epitaxial doping layer and the second epitaxial doping layer may be formed at the same time. Therefore, the doping concentrations of the first epitaxial doping layer and the second epitaxial doping layer may be set to be the same, and the thicknesses of the first epitaxial doping layer and the second epitaxial doping layer may be set to be the same.

According to a second aspect, this application provides a preparation method for a GAA transistor. The preparation method may include the following steps: forming, on a substrate, an initial fin, and a sacrificial gate and two side walls that cross the initial fin, where the initial fin includes sacrificial layers and channel layers that are stacked in an alternate and repeated manner, and the two side walls are respectively located on two sides of the sacrificial gate; removing a part of the initial fin exposed outside the two side walls; forming internal isolation portions on two sides of each sacrificial layer, where the internal isolation portion is located under the side wall; epitaxially growing a first epitaxial doping layer and a second epitaxial doping layer on the substrate, where the first epitaxial doping layer and the second epitaxial doping layer are respectively located outside the internal isolation portions; epitaxially growing a source in a region corresponding to the first epitaxial doping layer, and epitaxially growing a drain in a region corresponding to the second epitaxial doping layer; removing the sacrificial gate and the sacrificial layers, to form the plurality of floating channel layers; and forming a gate oxide layer and a gate layer between the two side walls. In this application, conductivity types of doped impurities in the first epitaxial doping layer and the second epitaxial doping layer are the same as a conductivity type of a doped impurity in the substrate, and counter with conductivity types of doped impurities in the source and the drain, and doping concentrations of the first epitaxial doping layer and the second epitaxial doping layer are greater than a doping concentration of the substrate.

In a feasible implementation, the first epitaxial doping layer and the second epitaxial doping layer on the substrate may be epitaxially grown on the substrate in the following manner: epitaxially growing a first doping layer and a second doping layer for at least one time on the substrate; and etching the first doping layer and the second doping layer, to remove the first doping layer and the second doping layer that are located on a side wall of the channel layer, so as to form the first epitaxial doping layer and the second epitaxial doping layer.

However, during specific implementation, when epitaxially grown on the substrate, the first doping layer and the second doping layer are also grown on a side wall of the initial fin. Consequently, when the first doping layer and the second doping layer that are located on the side wall of the channel layer are etched, the first doping layer and the second doping layer in a direction perpendicular to the substrate are also etched. Therefore, the first doping layer and the second doping layer may be grown and etched for a plurality of times, to ensure that the first epitaxial doping layer and the second epitaxial doping layer that are finally formed can meet specific thicknesses.

For example, the first doping layer and the second doping layer are epitaxially grown on the substrate for at least a plurality of times. After the first doping layer and the second doping layer are epitaxially grown each time, the first doping layer and the second doping layer are etched, to remove the first doping layer and the second doping layer that are located on the side wall of the channel layer. The first epitaxial doping layer and the second epitaxial doping layer may be formed until the first doping layer and the second doping layer are etched for a last time.

In a feasible implementation, when the first doping layer and the second doping layer are epitaxially grown, growth rates of the first doping layer and the second doping layer in the direction perpendicular to the substrate are greater than growth rates of the first doping layer and the second doping layer in a direction parallel to the substrate, to ensure that the first epitaxial doping layer and the second epitaxial doping layer that are formed are of specific thicknesses, and the first doping layer and the second doping layer do not exist on the side wall of the channel layer. In other words, thicknesses of the first doping layer and the second doping layer in the direction perpendicular to the substrate are greater than thicknesses of the first doping layer and the second doping layer in the direction parallel to the substrate. Therefore, during etching, it can be ensured that when etching of the first doping layer and the second doping layer on the side wall of the channel layer is completed, the first doping layer and the second doping layer that are of specific thicknesses still exist on the substrate.

For example, the growth rates of the first doping layer and the second doping layer in the direction perpendicular to the substrate are 20% greater than the growth rates of the first doping layer and the second doping layer in the direction parallel to the substrate.

In another feasible implementation, when the first doping layer and the second doping layer are etched, etching rates in the direction parallel to the substrate are greater than etching rates in the direction perpendicular to the substrate, to ensure that the first epitaxial doping layer and the second epitaxial doping layer that are formed are of specific thicknesses, and the first doping layer and the second doping layer do not exist on the side wall of the channel layer. Therefore, during etching, it can be ensured that when etching of the first doping layer and the second doping layer on the side wall of the channel layer is completed, the first doping layer and the second doping layer that are of specific thicknesses still exist on the substrate.

For example, when the first doping layer and the second doping layer are etched, the etching rates in the direction parallel to the substrate are two times greater than the etching rates in the direction perpendicular to the substrate. For example, the etching rates in the direction parallel to the substrate are three times, four times, or five times greater than the etching rates in the direction perpendicular to the substrate.

Optionally, in this application, when the first doping layer and the second doping layer are epitaxially grown, the growth rates of the first doping layer and the second doping layer in the direction perpendicular to the substrate are greater than the growth rates of the first doping layer and the second doping layer in the direction parallel to the substrate, to ensure that the first epitaxial doping layer and the second epitaxial doping layer that are formed are of specific thicknesses, and the first doping layer and the second doping layer do not exist on the side wall of the channel layer. When the first doping layer and the second doping layer are etched, the etching rates in the direction parallel to the substrate are greater than the etching rates in the direction perpendicular to the substrate.

To prevent the first epitaxial doping layer and the second epitaxial doping layer from being formed on the side wall of the channel layer, an isolation portion may be formed on the side wall of the channel layer, the first epitaxial doping layer and the second epitaxial doping layer are epitaxially grown, and after the first epitaxial doping layer and the second epitaxial doping layer are formed, the isolation portion on the side wall of the channel layer is removed.

In a feasible implementation, the forming internal isolation portions on two sides of each sacrificial layer and epitaxially growing a first epitaxial doping layer and a second epitaxial doping layer on the substrate may include: removing the sacrificial layer under the two side walls; forming the internal isolation portions on the two sides of each sacrificial layer and two sides of each channel layer; epitaxially growing the first epitaxial doping layer and the second epitaxial doping layer on the substrate, where the first epitaxial doping layer and the second epitaxial doping layer are respectively located outside the internal isolation portions; and removing the internal isolation portions located outside each channel layer, and reserving the internal isolation portions located on the two sides of each sacrificial layer.

According to the GAA transistor provided in embodiment of this application, on the basis of a conventional GAA transistor, the first epitaxial doping layer is epitaxially grown between the substrate and the source, and the second epitaxial doping layer is epitaxially grown between the substrate and the drain, to cut off an electricity leakage channel, on the substrate, between the source and the drain. In comparison with an existing electricity leakage suppression technology for a substrate of the GAA component, in this application, two feasible manners may be integrated into the conventional GAA component process step, and the doping concentrations of the first epitaxial doping layer and the second epitaxial doping layer may be maintained below 10¹⁸/cm³, to suppress both a parasitic leakage of the substrate and a BTBT electricity leakage.

According to a third aspect, this application provides an electronic device. The electronic device includes a circuit board, and the GAA transistor, disposed on the circuit board, in the first aspect or the implementations of the first aspect. A problem-resolving principle of the electronic device is similar to that of the foregoing GAA transistor. Therefore, for implementation of the electronic device, refer to implementation of the foregoing GAA transistor. Details are not described herein again.

For technical effect that can be achieved in the third aspect, refer to the descriptions of technical effect that can be achieved in any one of the possible designs in the first aspect. Details are not described herein again.

### BRIEF DESCRIPTION OF DRAWINGS

FIG. 1 is a diagram of a cross-sectional structure of a conventional GAA transistor;
FIG. 2 is a diagram of a cross-sectional structure of a GAA transistor in a related technology;
FIG. 3 is a diagram of a structure of a GAA transistor according to an embodiment of this application;
FIG. 4 is a flowchart of a preparation method of a GAA transistor according to an embodiment of this application;
FIG. 5a to FIG. 5e are diagrams of partial structures of a GAA transistor in a preparation process according to an embodiment of this application;
FIG. 6 is a diagram of a simulation result of simulation performed by using a TCAD according to an embodiment of this application; and
FIG. 7 is a diagram of a structure of an electronic device according to an embodiment of this application.

### Reference numerals:

1: GAA transistor; 01: substrate;
02: fin; 021: channel layer;
022: sacrificial layer; 031: source;
032: drain; 041: first epitaxial doping layer;
042: second epitaxial doping layer; 05: internal isolation portion;
06: gate structure; 061: side wall;
062: gate oxide layer; 063: gate layer;
07: sacrificial gate; 08: counterion implantation region;
09: shallow trench isolation portion; 10: electronic device;
11: circuit board; and 12: housing.

### DESCRIPTION OF EMBODIMENTS

To make objectives, technical solutions, and advantages of this application clearer, the following further describes this application in detail with reference to accompanying drawings. However, example implementations may be implemented in a plurality of forms and should not be construed as being limited to implementations described herein. On the contrary, these implementations are provided such that this application is more comprehensive and complete and fully conveys the concept of the example implementations to a person skilled in the art. Identical reference numerals in the accompanying drawings denote identical or similar structures. Therefore, repeated description thereof is omitted. Expressions of locations and directions in this application are described by using the accompanying drawings as an example. However, changes may also be made as required, and all the changes fall within the protection scope of this application. The accompanying drawings in this application are merely used to illustrate relative position relationships and do not represent an actual scale.

It should be noted that specific details are set forth in the following descriptions for ease of fully understanding this application. However, this application can be implemented in a plurality of manners different from those described herein, and a person skilled in the art can perform similar promotion without departing from the connotation of this application. Therefore, this application is not limited to the following disclosed specific implementations. The following descriptions of this specification are example implementations of this application. However, the descriptions are intended to describe the general principle of this application, and are not intended to limit the scope of this application. The protection scope of this application shall be defined by the appended claims.

For ease of understanding the technical solutions provided in embodiments of this application, the following first describes application scenarios of the technical solutions.

Because a gate structure of a GAA transistor may be disposed around a channel to ideally control the channel, the GAA transistor provided in embodiments of this application may be widely used as a component of an electronic device in various scenarios. For example, the electronic device may be a logic component or a processor. It should be noted that the GAA transistor provided in embodiments of this application is intended to include but is not limited to being applied to these and any other suitable types of electronic devices.

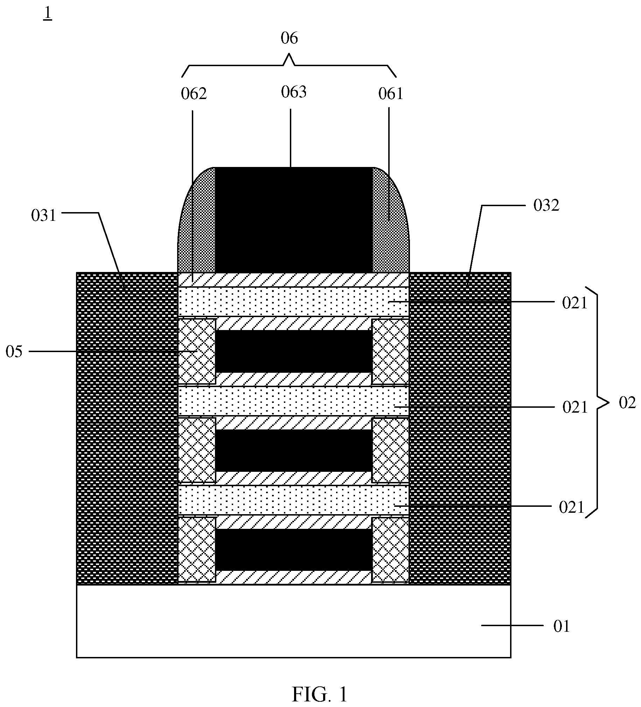

FIG. 1 is a diagram of a structure of a conventional GAA transistor. A GAA transistor 1 mainly includes a substrate 01, a fin 02 located on the substrate 01, a source and a drain that are respectively located on two sides of the fin 02, and a gate structure 06 that is located between the source and the drain and that covers the fin 02. The fin 02 includes a plurality of channel layers 021 that are stacked at intervals along a direction perpendicular to the substrate 01. The gate structure 06 includes: two side walls 061 disposed opposite to each other, a gate oxide layer 062 wrapping each channel layer 021, and a gate layer 063 filling a gap between the two side walls 061. Two internal isolation portions 05 are further disposed on a side that is of each of the plurality of channel layers 021 and that faces the substrate 01, and the internal isolation portions 05 are configured to isolate the gate layer 063 from the source 031 and the drain 032.

However, there is a parasitic leakage channel from the source 031 to the drain 032 under the channel layers 021 stacked in the GAA transistor 1, which is referred to as a parasitic leakage of the substrate. The parasitic leakage of the substrate is one of main challenges faced by the GAA transistor 1. As a channel length of the GAA transistor 1 is continuously downscaled, the parasitic leakage of the substrate becomes severer.

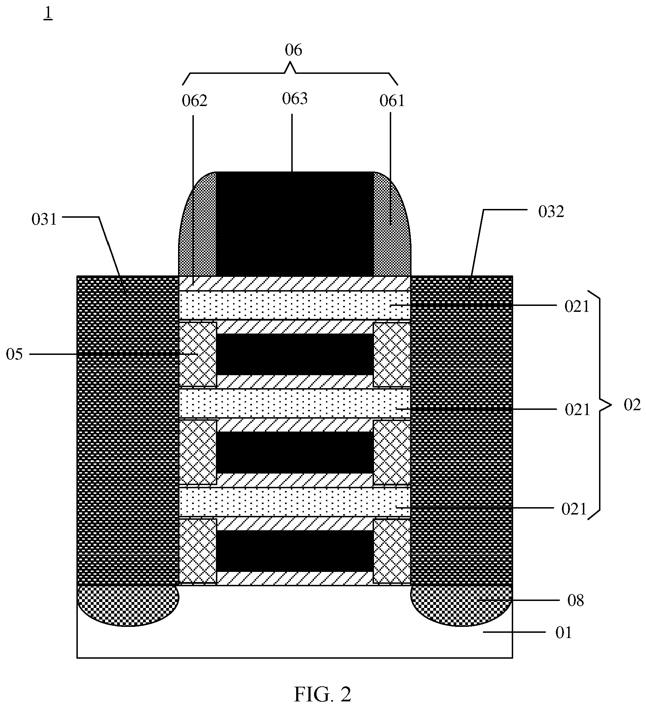

Refer to FIG. 2. In a related technology, a counterion implantation region 08 is formed by implanting counterions in regions corresponding to the source 031 and the drain 032 in the substrate 01, to increase a potential barrier, of the substrate 01, in a junction region between the source 031 and the drain 032. This can further suppress the parasitic leakage of the substrate. However, as the channel length decreases, short channel effect is enhanced, and counterions with a higher concentration need to be implanted. However, a junction structure may be steeper, and band-to-band tunneling (Band-to-band tunneling, BTBT) leakage between the drain and the substrate 01 becomes severer.

Therefore, embodiments of this application provide a GAA transistor, a preparation method thereof, and an electronic device, to reduce a parasitic leakage of a substrate. The following further describes in detail this application with reference to accompanying drawings.

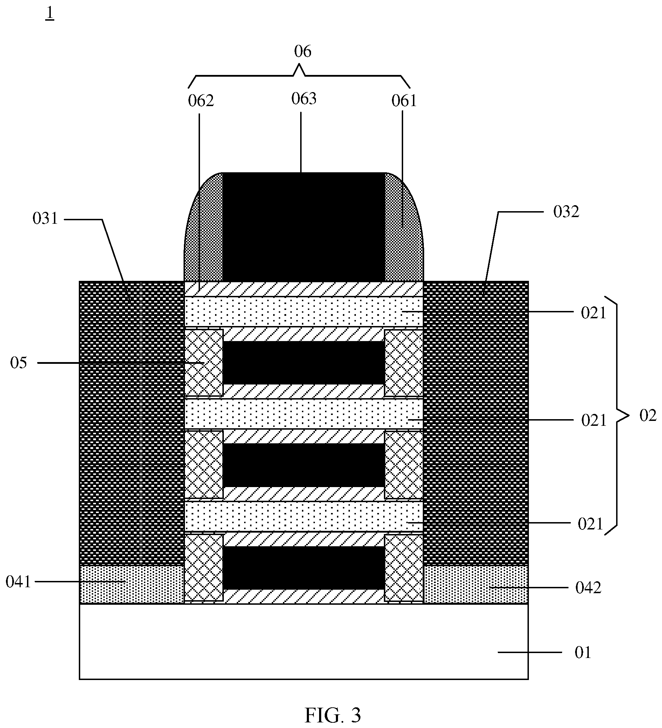

FIG. 3 is a diagram of a structure of a GAA transistor 1 according to an embodiment of this application. The GAA transistor 1 mainly includes a substrate 01, a fin 02 located on the substrate 01, a source 031 and a drain 032 that are respectively located on two sides of the fin 02, and a gate structure 06 that is located between the source 031 and the drain 032 and that covers the fin 02. To reduce a parasitic leakage of the substrate 01, the GAA transistor 1 may further include a first epitaxial doping layer 041 and a second epitaxial doping layer 042 that are respectively located on the two sides of the fin 02. The first epitaxial doping layer 041 is located between the substrate 01 and the source 031, and the second epitaxial doping layer 042 is located between the substrate 01 and the drain 032. Conductivity types of doped impurities in the first epitaxial doping layer 041 and the second epitaxial doping layer 042 are the same as a conductivity type of a doped impurity in the substrate 01, the conductivity types of the doped impurities in the first epitaxial doping layer 041 and the second epitaxial doping layer 042 counter with conductivity types of doped impurities in the source 031 and the drain 032, and doping concentrations of the first epitaxial doping layer 041 and the second epitaxial doping layer 042 are greater than a doping concentration of the substrate 01.

In this application, because the conductivity types of the doped impurities in the first epitaxial doping layer 041 and the second epitaxial doping layer 042 counter with the conductivity types of the doped impurities in the source 031 and the drain 032, an electricity leakage channel, on the substrate 01, between the source 031 and the drain 032 may be cut off through the first epitaxial doping layer 041 and the second epitaxial doping layer 042 on which counter-type doping is performed. In addition, both the first epitaxial doping layer 041 and the second epitaxial doping layer 042 are epitaxially grown on the substrate 01. Therefore, a depletion region including the first epitaxial doping layer 041 and the source 031 is limited in the first epitaxial doping layer 041, a depletion region including the second epitaxial doping layer 042 and the drain 032 is limited in the second epitaxial doping layer 042, and the depletion regions do not extend to the substrate 01. The depletion region including the first epitaxial doping layer 041 and the source 031 and the depletion region including the second epitaxial doping layer 042 and the drain 032 are separated in a direction parallel to the substrate 01, to greatly suppress the electricity leakage of the substrate 01.

In addition, as the channel length is downscaled, because the depletion region including the first epitaxial doping layer 041 and the source 031 and the depletion region including the second epitaxial doping layer 042 and the drain 032 are separated in the direction parallel to the substrate 01, the doping concentrations of the first epitaxial doping layer 041 and the second epitaxial doping layer 042 may remain to be low. This avoids a severer BTBT electricity leakage.

Therefore, the GAA transistor 1 provided in this application can obtain a better subthreshold swing, and as the channel length is continuously downscaled, a working voltage may also be continuously decreased while component performance is ensured.

Specific implementations of the fin 02 and the gate structure 06 in the GAA transistor 1 are not limited in this application, and the fin 02 and the gate structure 06 may be of any structure that can implement a function of the GAA transistor 1. For example, as shown in FIG. 3, the fin 02 may include a plurality of channel layers 021 stacked at intervals along a direction perpendicular to the substrate 01, and the gate structure 06 may include two side walls 061 disposed opposite to each other, a gate oxide layer 062 wrapping each channel layer 021, and a gate layer 063 filling a gap between the two side walls 061. To isolate the gate layer 063 from the source 031 and the drain 032, two internal isolation portions 05 are disposed on a side that is of each channel layer 021 and that faces the substrate 01, the two internal isolation portions 05 are isolated by the gate layer 063, one internal isolation portion 05 is located between the gate layer 063 and the source 031, and the other is located between the gate layer 063 and the drain 032.

To facilitate understanding of the GAA transistor 1 provided in embodiments of this application, the following further describes the GAA transistor 1 provided in embodiments of this application according to a preparation method. It should be noted that the following embodiments are merely used to describe feasibility of the GAA transistor 1 in this application, and do not limit the scope of this application.

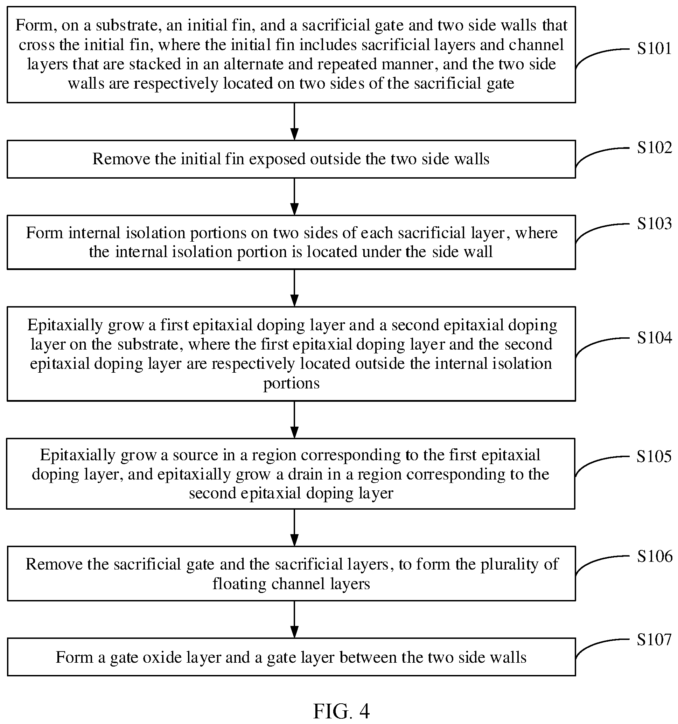

FIG. 4 is a flowchart of a preparation method of the GAA transistor 1 according to an embodiment of this application. The preparation method may include the following steps.

Step S101: Form, on a substrate, an initial fin, and a sacrificial gate and two side walls that cross the initial fin, where the initial fin includes sacrificial layers and channel layers that are stacked in an alternate and repeated manner, and the two side walls are respectively located on two sides of the sacrificial gate.

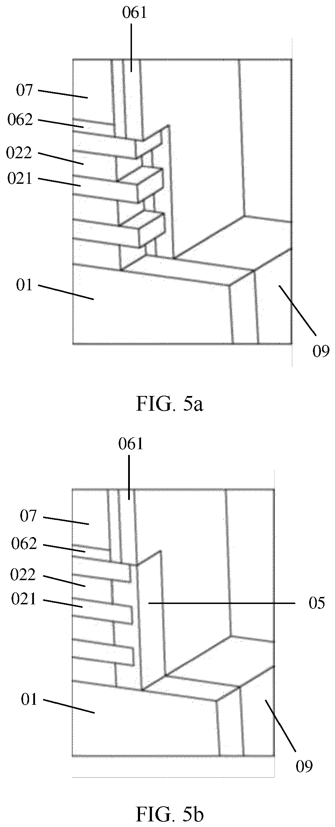

Refer to FIG. 5a to FIG. 5e. In a feasible implementation, the initial fin is first formed on the substrate 01, the sacrificial gate 07 crossing the initial fin is formed, and then the side walls 061 are respectively formed on the two sides of the sacrificial gate 07. In the accompanying drawings of this application, an example in which the GAA transistor 1 includes three sacrificial layers 022 and three channel layers 021 is used for illustration. It may be understood that, in the GAA transistor 1, a quantity of sacrificial layers 022 and a quantity of channel layers 021 may be determined based on an actual requirement of the component. This is not limited herein. For example, the quantity of sacrificial layers 022 and the quantity of channel layers 021 may be set based on conductivity of the GAA transistor 1.

Refer to FIG. 5a to FIG. 5e. Optionally, before the sacrificial gate 07 is formed, a gate oxide layer 062 that covers the initial fin may be further formed.

During specific implementation, when the GAA transistor is prepared, a large quantity of GAA transistors are usually formed on the substrate, and are cut based on a requirement. Refer to FIG. 5a to FIG. 5e. To isolate different GAA transistors in a preparation process, in an embodiment, before the side walls 061 are formed on the two sides of the sacrificial gate 07, a shallow trench isolation (Shallow trench isolation, STI) portion 09 is further formed between adjacent components, and then the side walls 061 are formed.

Thicknesses of the sacrificial layer and the channel layer are not limited in this application, and the thicknesses of the sacrificial layer and the channel layer may be set based on an actual requirement of the GAA transistor.

In this application, the substrate may be made of a semiconductor material. For example, a material of the substrate may be silicon.

In this application, the sacrificial layer may be made of a material having a lattice constant similar to that of the channel layer, and in a same etching process, an etch selectivity of the sacrificial layer to the channel layer is high. In this way, during subsequent selective etching, the sacrificial layer may be etched off, and the channel layer is reserved, to form a floating channel layer.

For example, the channel layer may be made of an Si semiconductor material, and the sacrificial layer may be made of an SiGe semiconductor material.

During specific implementation, in the initial fin, the bottom layer is the sacrificial layer, and the top layer is the channel layer. During preparation, the sacrificial layers and the channel layers may be successively epitaxially grown on the substrate, and epitaxial growth is repeated for a plurality of times, to form a plurality of sacrificial layers and the plurality of channel layers that are sequentially stacked. Then, the sacrificial layers and the channel layers are patterned through a patterning process, to form the initial fin.

During specific implementation, the sacrificial gate may be extended in a direction perpendicular to an extension direction of the initial fin.

For example, the side wall may be made of a material with a low dielectric constant, for example, including but not limited to silicon nitride, silicon oxide, silicon nitride, silicon carbon oxide, and a combination thereof.

Step S102: Remove a part of the initial fin exposed outside the two side walls.

Step S103: Form internal isolation portions on two sides of each sacrificial layer, where the internal isolation portion is located under the side wall.

In this application, the internal isolation portion may be made of a material with a low dielectric constant, and the internal isolation portion may physically isolate the source, the drain, and the gate layer that is subsequently formed in a floating region, to reduce parasitic capacitance.

Step S104: Epitaxially grow a first epitaxial doping layer and a second epitaxial doping layer on the substrate, where the first epitaxial doping layer and the second epitaxial doping layer are respectively located outside the internal isolation portions.

Conductivity types of doped impurities in the first epitaxial doping layer and the second epitaxial doping layer are the same as a conductivity type of a doped impurity in the substrate, and counter with conductivity types of doped impurities in the source and the drain, and doping concentrations of the first epitaxial doping layer and the second epitaxial doping layer are greater than a doping concentration of the substrate.

For example, if the conductivity types of the doped impurities in the source and the drain are an N type, conductivity types of doped impurities in the first epitaxial doping layer, the second epitaxial doping layer, and the substrate are a P type. If the conductivity types of the doped impurities in the source and the drain are the P type, the conductivity types of the doped impurities in the first epitaxial doping layer, the second epitaxial doping layer, and the substrate are the N type.

In this application, because a depletion region including the first epitaxial doping layer and the source and a depletion region including the second epitaxial doping layer and the drain are separated in the direction parallel to the substrate, the doping concentrations of the first epitaxial doping layer and the second epitaxial doping layer may remain to be low. For example, a doping concentration of the first epitaxial doping layer is less than or equal to 5*10¹⁸/cm³, and a doping concentration of the second epitaxial doping layer is less than or equal to 5*10¹⁸/cm³.

In an embodiment, the doping concentration of the first epitaxial doping layer may be controlled to be less than 10¹⁸/cm³, and the doping concentration of the second epitaxial doping layer may be controlled to be less than 10¹⁸/cm³.

Thicknesses of the first epitaxial doping layer and the second epitaxial doping layer are not limited in this application. For example, the thickness of the first epitaxial doping layer may be set to 5 nm to 25 nm, for example, 5 nm, 7 nm, 10 nm, 15 nm, 20 nm, or 25 nm., and the thickness of the second epitaxial doping layer may be set to 5 nm to 25 nm, for example, 5 nm, 7 nm, 10 nm, 15 nm, 20 nm, or 25 nm.

For example, in this application, the first epitaxial doping layer and the second epitaxial doping layer may be formed at the same time. Therefore, the doping concentrations of the first epitaxial doping layer and the second epitaxial doping layer may be set to be the same, and the thicknesses of the first epitaxial doping layer and the second epitaxial doping layer may be set to be the same.

Step S105: Epitaxially grow a source in a region corresponding to the first epitaxial doping layer, and epitaxially grow a drain in a region corresponding to the second epitaxial doping layer.

During specific implementation, materials of the source and the drain are the same, and the materials of the source and the drain may be set based on a structure of the component.

When the GAA transistor is a P-type transistor, the materials of the source and the drain may be P-type doped semiconductors. For example, the P-type doped semiconductor is a P-type doped silicon-germanium semiconductor. Doped P-type ions may be trivalent ions, for example, boron, aluminum, or gallium ions.

When the GAA transistor is an N-type transistor, the materials of the source and the drain may be N-type doped semiconductors. For example, the N-type doped semiconductor is an N-type doped silicon semiconductor. The doped N-type ions may be pentavalent ions, for example, nitrogen, phosphorus, or arsenic ions.

Step S106: Remove the sacrificial gate and the sacrificial layers, to form the plurality of floating channel layers.

During specific implementation, the sacrificial gate may be removed by using a dry etching method, a wet etching method, or a combination thereof. This is not limited herein.

During specific implementation, the sacrificial layer may be removed by using the dry etching method or the wet etching method. This is not limited herein.

For example, the sacrificial layer in the initial fin may be selectively etched at an etching rate higher than that of the channel layer, so that the reserved channel layer is disposed in a floating manner. Herein, the floating channel layer may be referred to as a nanowire channel.

Step S107: Form a gate oxide layer and a gate layer between the two side walls.

In a feasible implementation, the gate oxide layer that wraps each channel layer may be first formed, and then the gate layer is formed between the two side walls.

During specific implementation, the fully enclosed gate oxide layer may be formed on a surface of each channel layer by using an atomic layer deposition method or a low-pressure chemical vapor deposition method. For example, the gate oxide layer may be made of a material with a high dielectric constant, for example, an oxide or a nitrogen oxide of Si, titanium (Ti), zirconium (Zr), or hafnium (Hf). For example, the gate oxide layer may be a dielectric layer including any one of SiO₂, HfON, HfO₂, ZrO and TiO₂ or a stacked layer thereof.

During specific implementation, the gate layer may be formed on a surface of the gate oxide layer by using the atomic layer deposition method, until the gate layer completely fills a gap between the two side walls. For example, the gate layer may be made of titanium, titanium nitride, aluminum, tungsten, or tantalum nitride, or may be a stacked layer made of the foregoing materials.

An execution sequence of the foregoing steps is not limited in this application. Specifically, the execution sequence of the foregoing steps may be adjusted based on an actual situation.

In this application, the first epitaxial doping layer 041 and the second epitaxial doping layer 042 are epitaxially grown on the substrate 01 under the source 031 and the drain 032. Because the conductivity types of the doped impurities in the first epitaxial doping layer 041 and the second epitaxial doping layer 042 counter with the conductivity types of the doped impurities in the source 031 and the drain 032, an electricity leakage channel, on the substrate 01, between the source 031 and the drain 032 may be cut off by using the first epitaxial doping layer 041 and the second epitaxial doping layer 042 on which counter-type doping is performed. In addition, both the first epitaxial doping layer 041 and the second epitaxial doping layer 042 are epitaxially grown on the substrate 01. Therefore, the depletion region including the first epitaxial doping layer 041 and the source 031 is limited in the first epitaxial doping layer 041, the depletion region including the second epitaxial doping layer 042 and the drain 032 is limited in the second epitaxial doping layer 042, and the depletion regions do not extend to the substrate 01. The depletion region including the first epitaxial doping layer 041 and the source 031 and the depletion region including the second epitaxial doping layer 042 and the drain 032 are separated in a direction parallel to the substrate 01, to greatly suppress the electricity leakage of the substrate 01.

In a feasible implementation, the first epitaxial doping layer and the second epitaxial doping layer on the substrate may be epitaxially grown on the substrate in the following manner: after step S103 is completed, epitaxially growing a first doping layer and a second doping layer for at least one time on the substrate; and etching the first doping layer and the second doping layer, to remove the first doping layer and the second doping layer that are located on a side wall of the channel layer, so as to form the first epitaxial doping layer and the second epitaxial doping layer.

However, during specific implementation, when epitaxially grown on the substrate, the first doping layer and the second doping layer are also grown on a side wall of the initial fin. Consequently, when the first doping layer and the second doping layer that are located on the side wall of the channel layer are etched, the first doping layer and the second doping layer in a direction perpendicular to the substrate are also etched. Therefore, the first doping layer and the second doping layer may be grown and etched for a plurality of times, to ensure that the first epitaxial doping layer and the second epitaxial doping layer that are finally formed can meet specific thicknesses.

For example, the first doping layer and the second doping layer are epitaxially grown on the substrate for at least a plurality of times. After the first doping layer and the second doping layer are epitaxially grown each time, the first doping layer and the second doping layer are etched, to remove the first doping layer and the second doping layer that are located on the side wall of the channel layer. The first epitaxial doping layer and the second epitaxial doping layer may be formed until the first doping layer and the second doping layer are etched for a last time.

In a feasible implementation, when the first doping layer and the second doping layer are epitaxially grown, growth rates of the first doping layer and the second doping layer in the direction perpendicular to the substrate are greater than growth rates of the first doping layer and the second doping layer in the direction parallel to the substrate, to ensure that the first epitaxial doping layer and the second epitaxial doping layer that are formed are of specific thicknesses, and the first doping layer and the second doping layer do not exist on the side wall of the channel layer. In other words, thicknesses of the first doping layer and the second doping layer in the direction perpendicular to the substrate are greater than thicknesses of the first doping layer and the second doping layer in the direction parallel to the substrate. Therefore, during etching, it can be ensured that when etching of the first doping layer and the second doping layer on the side wall of the channel layer is completed, the first doping layer and the second doping layer that are of specific thicknesses still exist on the substrate.

For example, the growth rates of the first doping layer and the second doping layer in the direction perpendicular to the substrate are 20% greater than the growth rates of the first doping layer and the second doping layer in the direction parallel to the substrate.

In another feasible implementation, when the first doping layer and the second doping layer are etched, etching rates in the direction parallel to the substrate are greater than etching rates in the direction perpendicular to the substrate, to ensure that the first epitaxial doping layer and the second epitaxial doping layer that are formed are of specific thicknesses, and the first doping layer and the second doping layer do not exist on the side wall of the channel layer. Therefore, during etching, it can be ensured that when etching of the first doping layer and the second doping layer on the side wall of the channel layer is completed, the first doping layer and the second doping layer that are of specific thicknesses still exist on the substrate.

For example, when the first doping layer and the second doping layer are etched, the etching rates in the direction parallel to the substrate are two times greater than the etching rates in the direction perpendicular to the substrate. For example, the etching rates in the direction parallel to the substrate are three times, four times, or five times greater than the etching rates in the direction perpendicular to the substrate.

Optionally, in this application, when the first doping layer and the second doping layer are epitaxially grown, the growth rates of the first doping layer and the second doping layer in the direction perpendicular to the substrate are greater than the growth rates of the first doping layer and the second doping layer in the direction parallel to the substrate, to ensure that the first epitaxial doping layer and the second epitaxial doping layer that are formed are of specific thicknesses, and the first doping layer and the second doping layer do not exist on the side wall of the channel layer. When the first doping layer and the second doping layer are etched, the etching rates in the direction parallel to the substrate are greater than the etching rates in the direction perpendicular to the substrate.

To prevent the first epitaxial doping layer and the second epitaxial doping layer from being formed on the side wall of the channel layer, an isolation portion may be formed on the side wall of the channel layer, the first epitaxial doping layer and the second epitaxial doping layer are epitaxially grown, and after the first epitaxial doping layer and the second epitaxial doping layer are formed, the isolation portion on the side wall of the channel layer is removed.

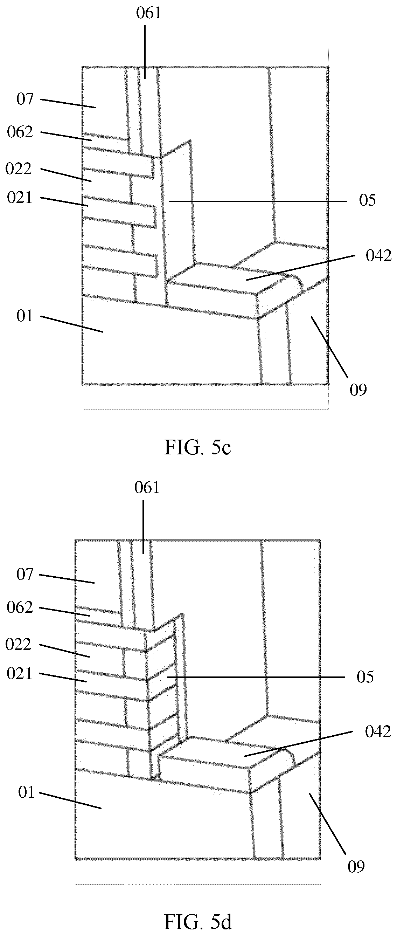

In a feasible implementation, the forming internal isolation portions on two sides of each sacrificial layer and epitaxially growing a first epitaxial doping layer and a second epitaxial doping layer on the substrate may include:
removing the sacrificial layer 022 under the two side walls 061, as shown in FIG. 5a;
forming the internal isolation portions 05 on the two sides of each sacrificial layer 022 and two sides of each channel layer 021, as shown in FIG. 5b;
epitaxially growing the first epitaxial doping layer 041 and the second epitaxial doping layer 042 on the substrate 01, where the first epitaxial doping layer 041 and the second epitaxial doping layer 042 are respectively located outside the internal isolation portions 05, as shown in FIG. 5c; and
removing the internal isolation portions 05 located outside each channel layer 021, and reserving the internal isolation portions 05 located on the two sides of each sacrificial layer 022, as shown in FIG. 5d.

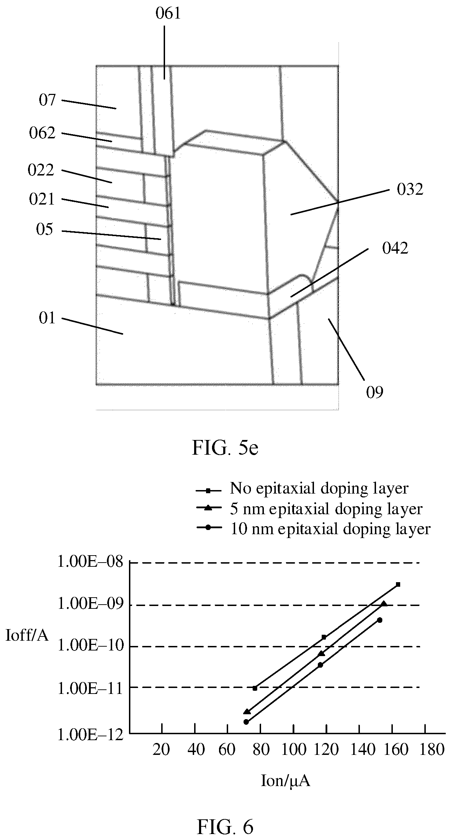

After the first epitaxial doping layer 041 and the second epitaxial doping layer 042 are epitaxially grown on the substrate 01, as shown in FIG. 5e, the source 031 is epitaxially grown in the region corresponding to the first epitaxial doping layer 041, and the drain 032 is epitaxially grown in the region corresponding to the second epitaxial doping layer 042. FIG. 5a to FIG. 5e show only a side of the drain 032 of the GAA transistor 1, and a side of the source 031 is usually symmetrical to the side of the drain 032.

According to the GAA transistor 1 provided in embodiment of this application, on the basis of a conventional GAA transistor 1, the first epitaxial doping layer 041 is epitaxially grown between the substrate 01 and the source 031, and the second epitaxial doping layer 042 is epitaxially grown between the substrate 01 and the drain 032, to cut off the electricity leakage channel, on the substrate 01, between the source and the drain. In comparison with an existing electricity leakage suppression technology for a substrate 01 of the GAA component, in this application, two feasible manners may be integrated into the conventional GAA component process step. In addition, the doping concentrations of the first epitaxial doping layer 041 and the second epitaxial doping layer 042 may be maintained below 10¹⁸/cm³, to suppress both a parasitic leakage of the substrate 01 and a BTBT electricity leakage.

For example, in this application, semiconductor process simulation and device simulation tools (Technology Computer Aided Design, TCAD) are used to simulate and verify suppression effect of the epitaxial doping layers (short for the first epitaxial doping layer and the second epitaxial doping layer) with different thickness (5 nm/10 nm) on the parasitic leakage of the substrate. Simulation results shown in FIG. 6 show that the epitaxial doping layer with a thickness of 10 nm and a concentration of 10¹⁸/cm³ can reduce the parasitic leakage of the substrate by 60% when a same turn-on current is ensured. Therefore, in this application, collaborative optimization of the process and the component can be performed by adjusting the thickness of the epitaxial doping layer.

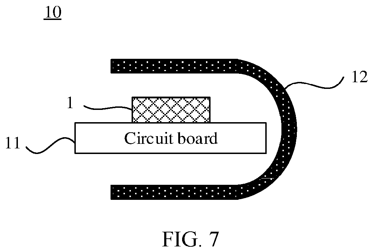

Correspondingly, refer to FIG. 7. An embodiment of this application further provides an electronic device 10, including a circuit board 11 and the GAA transistor 1 disposed on the circuit board 11. For example, the electronic device 10 further includes a housing 12, and the circuit board 11 is disposed in the housing 12. A problem-resolving principle of the electronic device 10 is similar to that of the foregoing GAA transistor 1. Therefore, for implementation of the electronic device 10, refer to implementation of the foregoing GAA transistor 1. Details are not described herein again.

It is clearly that a person skilled in the art can make various modifications and variations to this application without departing from the scope of this application. This application is intended to cover these modifications and variations of this application provided that they fall within the scope of protection defined by the following claims and their equivalent technologies.

## Claims

1. A gate-all-around transistor, comprising:
a substrate;
a fin located on the substrate;
a source and a drain that are respectively located on two sides of the fin;
a gate structure that is located between the source and the drain and that covers the fin; and
a first epitaxial doping layer and a second epitaxial doping layer that are respectively located on the two sides of the fin, wherein the first epitaxial doping layer is located between the substrate and the source, and the second epitaxial doping layer is located between the substrate and the drain, wherein
conductivity types of doped impurities in the first epitaxial doping layer and the second epitaxial doping layer are the same as a conductivity type of a doped impurity in the substrate, the conductivity types of the doped impurities in the first epitaxial doping layer and the second epitaxial doping layer counter with conductivity types of doped impurities in the source and the drain, and doping concentrations of the first epitaxial doping layer and the second epitaxial doping layer are greater than a doping concentration of the substrate.

2. The gate-all-around transistor according to claim 1, wherein a doping concentration of the first epitaxial doping layer is less than or equal to 5*10¹⁸/cm³; and
a doping concentration of the second epitaxial doping layer is less than or equal to 5* 10¹⁸/cm³.

3. The gate-all-around transistor according to claim 1 or 2, wherein a thickness of the first epitaxial doping layer is from 5 nm to 25 nm; and
a thickness of the second epitaxial doping layer is from 5 nm to 25 nm.

4. The gate-all-around transistor according to any one of claims 1 to 3, wherein the fin comprises a plurality of channel layers stacked at intervals along a direction perpendicular to the substrate;
the gate structure comprises: two side walls disposed opposite to each other, a gate oxide layer wrapping each channel layer, and a gate layer filling a gap between the two side walls; and
the gate-all-around transistor further comprises two internal isolation portions located on a side that is of each of the plurality of channel layers and that faces the substrate, and the two internal isolation portions are isolated by the gate layer.

5. An electronic device, comprising a circuit board and the gate-all-around transistor according to any one of claims 1 to 4 that is disposed on the circuit board.

6. A preparation method for a gate-all-around transistor, comprising:
forming, on a substrate, an initial fin, and a sacrificial gate and two side walls that cross the initial fin, wherein the initial fin comprises sacrificial layers and channel layers that are stacked in an alternate and repeated manner, and the two side walls are respectively located on two sides of the sacrificial gate;
removing a part of the initial fin exposed outside the two side walls;
forming internal isolation portions on two sides of each sacrificial layer, wherein the internal isolation portion is located under the side wall;
epitaxially growing a first epitaxial doping layer and a second epitaxial doping layer on the substrate, wherein the first epitaxial doping layer and the second epitaxial doping layer are respectively located outside the internal isolation portions;
epitaxially growing a source in a region corresponding to the first epitaxial doping layer, and epitaxially growing a drain in a region corresponding to the second epitaxial doping layer;
removing the sacrificial gate and the sacrificial layers, to form the plurality of floating channel layers; and
forming a gate oxide layer and a gate layer between the two side walls, wherein
conductivity types of doped impurities in the first epitaxial doping layer and the second epitaxial doping layer are the same as a conductivity type of a doped impurity in the substrate, the conductivity types of the doped impurities in the first epitaxial doping layer and the second epitaxial doping layer counter with conductivity types of doped impurities in the source and the drain, and doping concentrations of the first epitaxial doping layer and the second epitaxial doping layer are greater than a doping concentration of the substrate.

7. The preparation method according to claim 6, wherein the epitaxially growing a first epitaxial doping layer and a second epitaxial doping layer on the substrate comprises:
epitaxially growing a first doping layer and a second doping layer for at least one time on the substrate;
after epitaxially growing the first doping layer and the second doping layer each time, etching the first doping layer and the second doping layer, to remove the first doping layer and the second doping layer that are located on a side wall of the channel layer; and
after the first doping layer and the second doping layer are etched for a last time, forming the first epitaxial doping layer and the second epitaxial doping layer.

8. The preparation method according to claim 7, wherein when the first doping layer and the second doping layer are epitaxially grown, growth rates of the first doping layer and the second doping layer in a direction perpendicular to the substrate are greater than growth rates of the first doping layer and the second doping layer in a direction parallel to the substrate.

9. The preparation method according to claim 8, wherein the growth rates of the first doping layer and the second doping layer in the direction perpendicular to the substrate are 20% greater than the growth rates of the first doping layer and the second doping layer in the direction parallel to the substrate.

10. The production method according to claim 7, wherein when the first doping layer and the second doping layer are etched, etching rates in a direction parallel to the substrate are greater than etching rates in a direction perpendicular to the substrate.

11. The preparation method according to claim 10, wherein when the first doping layer and the second doping layer are etched, the etching rates in the direction parallel to the substrate are two times greater than the etching rates in the direction perpendicular to the substrate.

12. The preparation method according to claim 7, wherein the forming internal isolation portions on two sides of each sacrificial layer and epitaxially growing a first epitaxial doping layer and a second epitaxial doping layer on the substrate comprises:
removing the sacrificial layer under the two side walls;
forming the internal isolation portions on the two sides of each sacrificial layer and two sides of each channel layer;
epitaxially growing the first epitaxial doping layer and the second epitaxial doping layer on the substrate, wherein the first epitaxial doping layer and the second epitaxial doping layer are respectively located outside the internal isolation portions; and
removing the internal isolation portions located outside each channel layer, and reserving the internal isolation portions located on the two sides of each sacrificial layer.
